# EUROPEAN PATENT APPLICATION

(11) **EP 3 026 632 A2**
(43) Date of publication of application: **01.06.2016**
(21) Application number: 15275240.8
(22) Date of filing: 25.11.2015
(51) Int. Cl.: G06T 7/00, G06T 5/00

(54) **IMPROVEMENTS IN OR RELATING TO DIGITAL IMAGE CORRELATION SYSTEMS**

(30) Priority: 27.11.2014 GB 201421099
(71) Applicant: Airbus Operations Limited, Bristol BS34 7PA (GB)
(72) Inventor: SZIGETI, Eszter, Bristol, BS34 7PA (GB)
(74) Representative: Pearson, James Ginn

(57) **Abstract**

A random speckle pattern is displayed on a display screen (16) and the image then undergoes an imposed geometric transformation, for example being shifted by an integer number of pixels, the pixel pitch having been measured against a standard. The change in the image is measured by a digital image correlation ("DIC") system (10), which requires validation. The digital image correlation system (10) is then validated by comparing the known measured changes against the imposed geometric transformation. Traceability back to a measurement standard (37) can be provided by means of measuring the pixel pitch with a measuring device that is itself validated back to a measurement standard. A method of calibrating a DIC system is also described. The invention has particular application to validating computer models (240) of aircraft structures (243) and also certification of aircraft components.

## Description

### BACKGROUND OF THE INVENTION

The present invention concerns digital image correlation systems. More particularly, but not exclusively, this invention concerns methods of validating and/or calibrating a digital image correlation system. The invention also concerns a method of validating a computer model of a structure using such a digital image correlation system, a method of designing an aircraft structure in which a computer model of the structure is validated with the use of such a digital image correlation system, and related subject matter.

Particularly when designing a safety critical structure or load-bearing structure in an engineering context, it is desirable to model computationally the performance of the structure under different load conditions and also to be able to validate the model against experimental data. Digital Image Correlation (DIC) measurement systems may be used, in such a context, to compare numerical data that result from simulation of loads on a structure as defined by a computational model with experimental data from the DIC system resulting from applying actual loads on the corresponding physical structure.

Digital Image Correlation (DIC) is an optical (non-contact) measurement technique which is able to provide full-field displacement and strain data for a test specimen undergoing deformation. The technique uses a previously calibrated pair of digital cameras to capture stereo images of the test specimen (the structure to be measured, whether a test coupon or larger structure), to which a random speckle pattern has typically been applied. (In some cases a random speckle pattern may exist in some form as a natural consequence of the make-up and/or surface characteristics of the test specimen). As a result of the calibration, the change in shape of the specimen may be accurately calculated, using computer processing to track the movement of blocks of pixels, thus allowing full-field strain data to be ascertained.

DIC has been shown to be a powerful technique in both the validation and revision of computer-based models, such as finite element simulations or other computational solid mechanics models, as it can provide a full-field strain data map contrary to methods in which point measurements provided by individual strain gauges placed at certain points on the surface of the specimen are compared with corresponding point measurements predicted by the model.

It is desirable for the experimental data from the DIC system, against which the computational model is validated, to be properly calibrated, and for such calibration to be validated and traceable. The validation of the calibrated DIC system typically requires making measurements with reference to a known standard in order to establish the accuracy and uncertainty of the measurements made with the DIC system. Traceability requires that the validation method makes measurements that can be traced back, by an unbroken chain of comparisons, to a recognised (preferably nationally or internationally recognised) measurement standard.

The importance of being able to demonstrate that a given computer modelling simulation (for loading of structures, in particular) is valid and robust has been widely recognised. The use of Digital Image Correlation is widely accepted as a means of performing such validation. There is therefore a need for a robust method of validating a given DIC system in a traceable manner. Unsurprisingly, there has therefore been a concerted effort to generate a standard validation method, for validating a given DIC system, in such a way that is accepted by the engineering community as providing the very high levels of confidence that are typically required in engineering design. Several multi-party projects have been undertaken having this goal in mind.

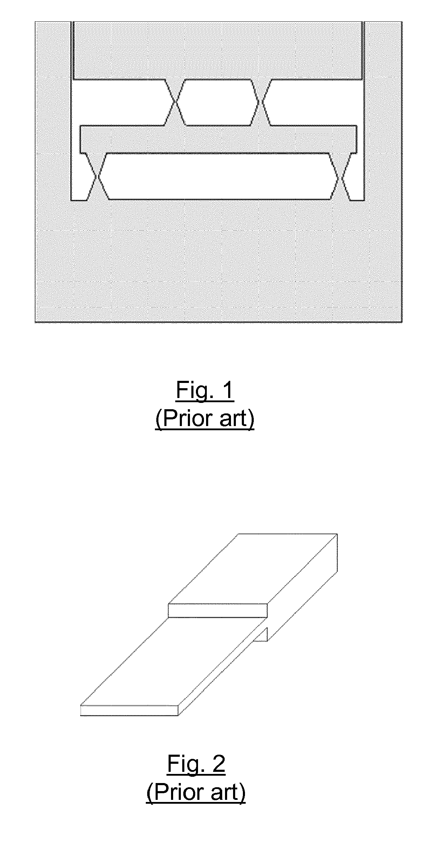

Such projects includes the VANESSA project (a project relating to "VAlidation of Numerical Engineering Simulations: Standardisation Actions"), coordinated by the European Committee for Standardization ("CEN" - Comité Européen de Normalisation) under CEN Workshop Agreement No. CEN/WS71. A related (draft) paper published under the VANESSA project, entitled "Validation of Computational Solid Mechanics Models" dated June 2014 has been made available on the Internet at http://www.engineeringvalidation.org/?download=CWA%20VANESSA.pdf (referred to in this patent specification as the "VANESSA paper"). The project seeks to define an internationally recognised process (much like a standard) for the validation of computational solid mechanics model using strain fields from calibrated measurement systems, particularly optical measurement systems such as DIC. The project seeks to define standard methods for calibration of optical systems for measurement of strain fields and for validation using the strain field data. In the proposed methods, data from measurements carried out on standard reference materials (calibration artefacts) are compared to numerical predictions and/or single point conventional measurements. The VANESSA paper proposes the use of a beam reference material, to which a four point bending load may be applied, when validating for measurements of in-plane static loading. Such a beam reference material is shown schematically in Figure 1 of the attached drawings and is also illustrated in the Community Registered Design published under number 000213467-0001. When validating for out-of-plane static or dynamic loading, a cantilever beam is proposed as schematically shown in Figure 2 of the attached Figures. The Vanessa paper discloses a theoretical model, in the form of various formulae, for predicting the strain and displacement fields that will be produced by the reference materials when loaded.

The Vanessa paper proposes that measurements made by a calibrated DIC system be validated by using the same calibrated DIC system to measure the strain field resulting when known loads are applied to at least one of the standardised reference materials. The strain field measured by the DIC system is compared against the strain field as calculated using the theoretical model. This then yields a level of uncertainty in the DIC system's measurements.

Much effort has been expended in agreeing and developing guidelines in relation to the standardised reference materials. The proposed monolithic four point bend beam (as shown in Figure 1) has been carefully designed for use in terms of strain measurement and calibration, traceable back to a standard, which can be achieved through the use of a displacement transducer previously calibrated to the standard for length. Much effort has also been expended, by academia and industry, in agreeing, developing and justifying the calibration and validation methods of the type that are the subject of the VANESSA project. Further details are provided in a recent CEN Workshop Agreement (No. CWA 16799) publication of September 2014, which sets out various methods for calibration of DIC systems and the protocol for validation of such systems using strain field data. This work is widely regarded as being of a high standard and shows current best practice in the field as perceived by many highly-respected parties.

Despite the efforts made to date, there are various disadvantages to the methods proposed in the prior art. Firstly, they use theoretical numerical-based predictions as the values for comparison to the DIC measurements. Such theoretical numerical-based predictions are limited to how close the behaviour of the reference material in reality matches that as predicted by theory. The prior art methods essentially assume that the reference material behaves exactly as predicted. Secondly, it is unsatisfactory for a DIC-measurement system to be used to validate numerical models of structural components to itself be reliant on a validation method, which validates the same DIC-measurement system on the same types of numerical models. Thirdly, the provision of a specific standard reference material and protocol for validating the DIC measurement system is unsatisfactory if there is great variation between the characteristics of the validation and the characteristics of the practical uses to which the DIC-based measurement system is put (e.g. differences in the type of, size of and loading applied to the specimen, field of view or other parameters of the set-up and/or environmental conditions).

As mentioned above, it is desirable for there to be provided a clear route for traceability to a measurement standard. The suggestion in the prior art mentioned above is that traceability may be provided by means of the use of remote displacement transducers (previously calibrated to the standard for length). The use of such a means of traceability is also reliant on the accuracy of the theoretical models provided concerning the behaviour of the reference materials when under load, and also depends on where on the reference material the displacement transducers are mounted. That then has the same disadvantage as validating a full-field numerical model by experimental point measurements: the procedures propose to calibrate a full-field measurement technique using devices that only provide point measurements.

The present invention seeks to mitigate one or more of the above-mentioned problems and disadvantages. Alternatively or additionally, the present invention seeks to provide an improved method of validating and/or calibrating a digital image correlation system. Alternatively or additionally, the present inventor believes, despite the excellent work resulting from CEN projects mentioned above, that there may be alternative solutions to those proposed in the prior art, such alternative solutions possibly providing advantages of simplicity and other potential benefits.

### SUMMARY OF THE INVENTION

The present invention provides, according to a first aspect, a method of validating a digital image correlation system, wherein the method comprises the following steps:
a) displaying a random speckle pattern, as a first image, on a display screen having a stack of a plurality of lines of pixels, adjacent pixels in each line being separated by a known pitch, the pitch having been measured against a standard,
b) using the digital image correlation system that requires validation to take a first set of measurements of the random speckle pattern,
c) displaying a second image, in which the random speckle pattern of the first image has undergone an imposed geometric transformation, such that one or more blocks of the first image are mapped onto one or more blocks of the second image in a one-to-one mapping, each block being represented on screen as an integer number of pixels,
d) ascertaining a measured geometric transformation including taking a second set of measurements with the digital image correlation of the random speckle pattern, and
e) comparing the imposed geometric transformation and the measured geometric transformation.

According to a second aspect of the invention there is also provided a method of calibrating a digital image correlation system, wherein the method comprises the following steps:
a) displaying a known pattern on a display screen having a stack of a plurality of lines of pixels, the centres of adjacent pixels in each line being separated by a known pitch, and the distance from the centreline of one line of pixels to the centreline of an adjacent line of pixels being a known separation distance, the pitch and the separation distance each having been measured against a standard,
b) using the digital image correlation system that requires calibration to take a set of measurements of the known pattern,
c) repeating steps a) and b) above a plurality of times, and
d) calculating calibration parameters for the digital image correlation system from the results of step c).

According to a third aspect of the invention there is also provided a digital image correlation system as validated by a method according to any aspect of the present invention as claimed or described herein, including any optional features relating thereto.

According to a fourth aspect of the invention there is also provided a method of validating a computer model of a structure, wherein the method comprises the following steps:
i. performing the method according to any aspect of the present invention as claimed or described herein, including any optional features relating thereto, so as to provide a validated digital image correlation system,
ii. immediately before or after step i), using the digital image correlation system to take a first image of a speckle pattern applied to a structure made according to the computer model,
iii. applying a load to the structure,
iv. using the digital image correlation system to take a second image of the speckle pattern,
v. using the digital image correlation system to calculate the strain field,
vi. comparing the strain field resulting from the measurements made with the validated digital image correlation system with a corresponding strain field as predicted with the computer model.

According to a fifth aspect of the invention there is also provided a method of designing an engineering structure, for example an aircraft structure, comprising the steps of
a) creating a computer model of the structure,
b) making predictions, with the use of the computer model, concerning the behaviour of the structure as between first and second loading conditions,
c) making a physical model of the structure,
d) applying a random speckle pattern on at least a part of the physical model of the structure,
e) using a digital image correlation system to take a first set of measurements of the random speckle pattern, under a first load condition,
f) applying to the physical model of the structure a second load condition, being different from the first load condition,
g) taking a second set of measurements with the digital image correlation system of the random speckle pattern, under the second load condition,
h) ascertaining the observed behaviour of the physical model of the structure with the digital image correlation system,
i) validating the computer model by means of a comparison between the predicted behaviour and the observed behaviour, and
j) validating the digital image correlation system by means of performing the method according to any aspect of the present invention as claimed or described herein, including any optional features relating thereto.

According to a sixth aspect of the invention there is also provided an aircraft component including an aircraft structure made from a computer model of the aircraft structure, which has been validated by the method according to any aspect of the present invention as claimed or described herein, including any optional features relating thereto.

According to a seventh aspect of the invention there is also provided a method of certifying an aircraft structure, comprising the steps of
a) providing a loading profile to be applied to an aircraft structure,
b) providing certification behaviour criteria with which the aircraft structure must comply when loaded by the loading profile,
c) applying the loading profile to the aircraft structure on which there is provided a random speckle pattern,
d) using a digital image correlation system to take measurements both before the loading profile is applied and during when the loading profile is applied,
e) ascertaining the observed behaviour of the aircraft structure with the digital image correlation system of the third aspect of the invention, and
f) ascertaining whether the observed behaviour complies with the certification behaviour criteria.

According to an eighth aspect of the invention there is also provided an aircraft component including an aircraft structure certified by the method according to any aspect of the present invention as claimed or described herein, including any optional features relating thereto.

According to a ninth aspect of the invention there is also provided a portable computer with a display screen, wherein the portable computer is programmed with a computer program product configured to cause, when the computer program is executed, the portable computer to perform steps a) and c) of the first aspect of the invention as claimed or described herein, including any optional features relating thereto.

According to an tenth aspect of the invention there is also provided a computer system including a display screen and being connected to form part of a digital image correlation system, wherein the computer system is programmed with one or more computer program products configured to cause, when the computer program is executed, the computer system to perform the steps of the method according to any aspect of the present invention as claimed or described herein, including any optional features relating thereto.

According to a eleventh aspect of the invention there is also provided a computer program product configured, when the computer program is executed on a computer, either to cause the computer to perform some or all of the steps of a method according to any aspect of the present invention as claimed or described herein, including any optional features relating thereto, or to provide a computer that defines or forms part of an apparatus according to any aspect of the present invention as claimed or described herein, including any optional features relating thereto.

It will of course be appreciated that features described in relation to one aspect of the present invention may be incorporated into other aspects of the present invention. For example, the method of the invention may incorporate any of the features described with reference to the apparatus of the invention and *vice versa.*

### DESCRIPTION OF THE DRAWINGS

Embodiments of the present invention will now be described by way of example only with reference to the accompanying schematic drawings of which:
Figure 1 shows a first test reference material, in the form of a four-point loaded beam, known in the prior art;
Figure 2 shows a second test reference material, in the form of a cantilever beam, known in the prior art;
Figure 3 shows a digital image correlation system being validated according to a first embodiment of the invention;
Figure 4 shows a part of a speckle pattern represented by an array of pixels as used in the first embodiment of the invention;
Figure 5 shows part of a speckle pattern of a first image used in the first embodiment of the invention;
Figure 6 shows part of a speckle pattern of a second image used in the first embodiment of the invention;
Figure 7 shows, in relation to the first embodiment of the invention, a display screen used in the digital image correlation system and the way in which the coordinate system of the digital image correlation system is defined;
Figure 8 shows, in relation to the first embodiment of the invention, a chain of traceablity to a length standard;
Figure 9 shows a digital image correlation system being validated according to a second embodiment of the invention;
Figure 10 shows a digital image correlation system being used to validate a computer model of a structure according to a fifth embodiment of the invention; and
Figure 11 shows the use of a computer model validated by the digital image correlation system of Figure 10 to make an aircraft component for an aircraft.

### DETAILED DESCRIPTION

Embodiments of the present invention relate to methods of validating and/or calibrating a digital image correlation ("DIC") measurement system and related subject matter. In an example method according to the invention, a random speckle pattern is displayed on a display screen and the image is then shifted by an integer number of pixels (by means of an "imposed shift"), the pixel pitch having been measured against a standard. The shift in the image is measured by the digital image correlation ("DIC") system, which requires validation. The DIC system may then be validated by comparing the known shift against the imposed shift. Traceability back to a measurement standard can be provided by means of measuring the pixel pitch with a measuring device that is itself validated back to a measurement standard. There now follows a general description outlining the general concepts embodied by such embodiments.

DIC systems are of use, in particular, in measuring the deformation of a structure being viewed by the DIC system. The deformation exhibited by a structure under load may be ascertained by means of tracking the relative movement of portions of a random speckle pattern that is on the surface of the structure being deformed, for example before such a load is applied and during, or after, the application of the load. The corresponding strain field may be ascertained, for example essentially by means of a differentiation calculation, as is well understood in the art. The calculation of the strain field may be calculated by a part of the DIC system, but it may be calculating by post-proceeding the data on a computer system separate from the DIC system. In order to make the measurements from which such a strain field may be calculated, the DIC system needs to be calibrated. For the calibrated DIC system to be accepted as a valid measurement system having a well-defined accuracy, preferably traceable back to an officially recognised standard, it needs to be validated.

In accordance with the general concepts embodied by the embodiments of the invention, the method of validating a DIC system may comprise a step of displaying, as a first image, a random speckle pattern on a display screen and using the DIC system to take a first set of measurements of the random speckle pattern. The screen will typically have a stack of a plurality of lines of pixels, for example forming a regular array of pixels. The lines of pixel may for example form columns and rows. Each pixel is preferably the same size. Adjacent pixels in each line are separated by a known pitch. It will be appreciated that the pixel pitch may be ascertained by measuring a suitable distance, for example, a centre-to-centre distance or an edge-to-edge distance. The pixel pitch is preferably uniform along a line, for example the standard deviation of pixel pitch being no more than 0.5% of the pitch. It may be that the standard deviation of the pixel pitch is less than 0.1% of the pitch. (Most commercially available, "off the shelf", high definition monitors/displays have highly regular and uniform arrays of pixels.) The known pitch is preferably known by having been measured against a standard, whether directly or indirectly.

There may then be displayed on the display screen, a second image in which the random speckle pattern of the first image has undergone an imposed geometric transformation. The imposed geometric transformation has characteristics such that one or more blocks of the first image, being represented on screen as an integer number of pixels, are mapped, in a one-to-one mapping, onto one or more blocks of the second image, each block of which also being represented on screen as an integer number of pixels. The digital image correlation system is then used to take a second set of measurements of the random speckle pattern. A measured geometric transformation may then be ascertained. By comparing the imposed geometric transformation and the measured geometric transformation, the accuracy of the DIC system may be ascertained. Provided that the accuracy of the DIC system so ascertained is within a given threshold, or other validation criteria, the DIC system may be validated for subsequent use as a validated DIC system.

The imposed geometric transformation may be such that it comprises one or more of the following:
- a rotation of 90, 180 or 270 degrees,
- linear resizing, and
- a translation.

It may be that the imposed geometric transformation may be fully represented by a combination of one or more of the three actions listed above.

The linear resizing, if used, may be in the form of a skew, so that different rows, or columns, of image pixels are shifted by different amounts (of integer pixels). The linear resizing, if used, may mean that the number of display pixels for each block of the first image is different from the number of display pixels in each block of the second image, preferably by a factor which is an integer number. For example one image may be equal to the other image stretched by a factor of two in the direction along the line of pixels. Such resizing transformations may require an effective change of resolution as between the first image and the second image.

Whilst the above-described resizing operations may require that the number of display pixels for each block of the first image is different from the number of display pixels in each block of the second image, it is preferred for the number of display pixels for each block of the first image to be equal to the number of display pixels in each block of the second image. There may then be no need for interpolating, downscaling or upscaling the resolution of the random speckle pattern.

The geometric transformation may be such that individual blocks of the first image shift an integer number of pixels to form the individual blocks of the second image. In the case of a rotation of 90, 180, or 270 degrees, the individual display pixels may each be deemed to be a block, such that each block (display pixel) undergoes a rotation such that each block (unless it is the centre of the rotation) shifts an integer number of pixels as between the first image and the second image.

Preferably, the imposed geometric transformation is such that the one or more blocks of the first image, and the one or more blocks of the second image, are each represented on screen as a single pixel.

Preferably, the imposed geometric transformation is such the whole of the random speckle pattern is shifted as a translation of integer number of pixels. For example, it may be that the imposed geometric transformation causes a shift, in the direction along the length of each line of pixels, of the random speckle pattern on the display screen by an integer number of pixels. The validation of the digital image correlation system may then be effected by means of a comparison between the known distance represented said integer number of pixels (of the shift effected by the imposed geometric transformation) and the corresponding distance of the shift in the speckle pattern as determined with the digital image correlation system. The distance of the shift, when only in the direction along the length of each line of pixels, is of course equal to the integer number of pixels shifted multiplied by the pixel pitch. The comparison may, for example, include calculating a value of the measured shift, in terms of the number (not necessary an integer) pixels shifted, in terms of an absolute distance, or in terms of some other measure, and compare that with the corresponding distance/measure of the known pixel shift. Alternatively or additionally, a unitless quantity may be calculated that represents the closeness of the expected pixel shift amount and the observed pixel shift amount.

By ensuring that the imposed geometric transformation is one which utilises the display pixels of the display screen in such a way that the transformation effected is precisely known (and is capable of being measured precisely), the accuracy of the measured geometric transformation may be precisely tested.

Such embodiments provide a simple yet effective technique for the validation of DIC measurement systems. With this technique, 3D full-field validations of DIC measurements can be carried out in a simple and effective manner, providing both time and cost savings as compared to the proposals of the prior art. It is both known to display a single random speckle pattern on a display screen and known, separately, to use artificially produced deformation data in order to validate the algorithms used by a DIC measurement system. Despite this and despite the huge effort to agree a standard validation technique for validating a particular set-up of a DIC measurement system, the use of displaying and measuring shifts in successive random speckle images on a display screen has, it seems, not been recognised as a possible means for providing such a validating technique. In the context of the embodiments of the present invention, however, utilising the pixels of the display screen in the manner proposed (for example by imposing an integer pixel shift of the speckle pattern) gives rise to a measurable parameter known to a high degree of accuracy (in a traceable manner) that can be used to test (validate) the DIC system.

It will be appreciated that it is highly desirable for there to be no movement of either the digital image correlation system or the display screen between the first and second set of measurements. If there were such movement, the movement would need to be known to a high precision and traceable back to a standard, in order to be compensated for. For example, such compensation for any such movement (of the rigid body represented by the display screen) can be measured and accounted for by means of displaying a stationary image (for example a stationary random speckle pattern) on part of the display screen that remains stationary (relative to the display screen) as between taking the first and second set of measurements. If there is any movement (whether or not intentional) in the system set-up that can then be detected and compensated for.

There may be a step of shifting, in the direction perpendicular to the length of the line, the random speckle pattern. For example the pattern may be shifted in such a perpendicular direction by an integer number of pixels. Each line of pixels may be aligned generally horizontally. Each line of pixels may be aligned generally vertically. A line of pixels need not lie on a straight line in 3-dimensions. For example, the display screen pixels may be presented on a curved display screen.

The method may include a step of measuring the pitch of the pixels directly or indirectly against a standard. Typically, the pitch of the pixels will be measured with apparatus that has been calibrated in a way that is traceable back to such a standard. It may be that the measurement of the known pitch is traceable back to a national, or an international, standard of length (i.e. one that is officially recognised by a country, by a standards body, or similar authority), via a continuous chain of one or more comparisons. Each comparison in the chain may be associated with an established measurement uncertainty. The chain may thus yield both validation, with traceability back to a length standard, and also a measure of the uncertainty. Such traceability may facilitate the use of the validated DIC system within a regulatory environment, for example when certifying aircraft structures/components/parts. The distance from the centreline of one line of pixels to the centreline of an adjacent line of pixels is preferably a known separation distance, the separation distance also having been measured against a standard. (The "separation distance" may be considered to represent the pixel pitch in the perpendicular direction.)

Having in mind the desire for digital image correlation techniques to be firmly accepted as a sufficient robust and reliable displacement measurement system in the industrial arena, it is desirable for the validation of the DIC system to be performed in a manner than closely mirrors the conditions in which DIC system is used as a displacement measurement system, including performing validation at a time relatively close to the use of the DIC system as a displacement measurement system. The simplicity and flexibility of the methods of the presently described embodiments enable such conditions to be closely matched. The methods of the presently described embodiments also render the use of physical reference materials, of the type shown in Figures 1 and 2, unnecessary. Sensitivity and repeatability, of the validation, may be improved in comparison to such prior art methods.

The method may include a step of measuring the pitch of the pixels with the use of a suitable measuring device, for example a microscope. The performance of the microscope is preferably validated, directly or indirectly, against a standard. The microscope may for example be in the form of a travelling microscope with a calibration certificate. The microscope may for example be calibrated with the use of a reference length that is validated, directly or indirectly, against a standard. The reference length may be provided by means of a stage micrometre for example. The stage micrometre may be validated directly against the standard

The display screen may be in the form of an LCD display screen. The display screen may be in the form of an LED display screen. The display screen may be in the form of an e-ink display screen of the sort used by commercially available e-readers. The image(s) displayed may be monochrome, for example comprising various shades of one hue. The image(s) displayed may be two-colour, such that pixels are one colour or another (e.g. a binary colour map); for example the image(s) displayed may be purely black and white images. The image(s) displayed may be greyscale images. It may be that the random speckle pattern consists of pixels each having a colour that is equal to one of a set of colours, the set comprising more than three colours. The set may comprise at least ten colours. The set may consist of fewer than 300 colours, optionally fewer than 100. The set of colours may all be grey, black or white in colour. The term "colour" here is being used to refer to a single colour of a colour space, such as the RGB colour space, for example requiring at least three independent parameters to define the colour.

The display screen is preferably a high resolution screen, for example providing more than 500,000 pixels in total. The display screen is preferably in the form of a "high-definition" ("HD") screen or better.

It may be that at least one of the speckles of the random speckle pattern is represented by a single pixel. It may be that at least one of the speckles of the random speckle pattern is represented by a cluster of two or more pixels. It may be that the random speckle pattern is one block of a bigger pattern. The bigger pattern may also be a random speckle pattern. Other parts of the bigger pattern may also undergo geometric transformations as between the first image and the second image. For example, it may be that in addition to the step of shifting the random speckle pattern on the display screen by an integer number of pixels, the rest of the bigger random speckle pattern is also shifted, possibly by a different distance, and possibly such that different parts are shifted by different amounts. One or more parts of the bigger pattern may remain stationary, as between the first image and the second image, so as to provide a control measure that enables unintentional movement of the set-up to be detected and corrected for (as also mentioned above).

The random speckle pattern may be computer generated. Alternatively, the random speckle pattern may be derived from an image (for example a photograph) of a real-life random speckle pattern, which may be man-made or may result from random features that exist in any case on the surface of a structure.

The DIC system may be based on a single camera system, able to measure displacement in 2-D only. It is however preferred for the DIC system to comprise at least two cameras, thus providing the ability to determine the position of a point in three dimensions.

The DIC system typically comprises a computer. The computer may for example perform the step of validating the digital image correlation system. The computer may for example be programmed to cause the digital image correlation system to perform the function of a displacement measurement system. The computer may cause the display of the speckle pattern on the display screen. It may be that a separate computer causes the display of the speckle pattern on the display screen. For example, a portable computing device, such as a tablet computer, may display the speckle pattern on the display screen of the portable computing device. Thus, the display screen may form part of a tablet computer.

The method may include a step of moving the display screen to a new location, for example whilst leaving the camera(s) of the DIC system in place, and then displaying a random speckle pattern and taking further measurements with the DIC system. The validation method may be repeated having the display screen in two or more different locations, thus enabling a relatively small display screen to validate the DIC system over a relatively large field of view.

Many commercially provided display screens are planar. The present invention is not limited however to the use of planar screens. Indeed there may be benefit in using a non-planar display screen. It may be that the display screen is formed from flexible material, preferably such that it is able to conform to different shapes. The method may include conforming a display screen to match at least in part the geometry of the structure the deformation of which is to be measured / has been measured by the DIC system.

The method may include a step, which is conducted before the step of validating the digital image correlation system, of calibrating the digital image correlation system. Whereas validation techniques may be used to provide proof that the measurements made by a system are valid and accurate (to within a proven uncertainty, preferably), calibration techniques are typically used to set up, and optionally adjust the set-up of, a measurement system. Such a calibration may be performed with the use of a calibration board, as is conventional in the art. It is possible however for the same display screen to be used in calibrating the DIC system as is used in the validation method. It may for example be that the step of calibrating the digital image correlation system includes displaying a calibration pattern on the same display screen as is subsequently used to display the random speckle pattern. The calibration method may include a step of moving the display screen to a new location, for example whilst leaving the camera(s) of the DIC system in place, and then displaying a calibration pattern and taking further measurements with the DIC system. The calibration method may be repeated having the display screen in two or more different locations, thus enabling a relatively small display screen to be used to calibrate the DIC system over a relatively large field of view. It may be that the display screen is sufficiently large to match the field of view when located at a typical viewing distance (or "stand-off" distance). It will be appreciated from the forgoing description that the display screen may have a pixel size and/or pitch that is measured in a way that is traceable back to a recognised standard. Calibration may include calculating the calibration parameters, for example those parameters that account for the intrinsic and extrinsic properties of the DIC system setup.

The aforementioned calibration method may have independent application. Thus embodiments are envisaged which relate to the calibrating of a digital image correlation system, not necessarily also requiring validation at the same time. Alternatively, a validation method may be performed before or after such calibration but in a manner that is different from described or claimed herein. Such a calibration method may comprise a step of displaying a known pattern, for example a calibration pattern, on a display screen of the type referred to herein. The display screen thus has pixels being separated by a known pitch / separation measured against a standard. During a single calibration process, the digital image correlation system may then take successive measurements of the known pattern. Optionally, a different pattern may be used when performing a different calibration between measurements. From such data, the calibration parameters may then be ascertained. There may be two or more successive sets of such calibration measurements. The same calibration pattern may be used in successive sets of calibration measurements. The display screen may be moved between successive sets of calibration measurements, for example so as to cover more area with the field of view of the camera(s) of the DIC system. When the display screen is in the form of a tablet, this embodiment may present a convenient, flexible and cost-effective alternative to the use of the calibration boards that are conventionally used. The same display screen may be used to calibrate different DIC system set-ups, by means of using different pre-set calibration patterns.

The display screen used may be in the form of other portable / pre-existing display screens. Ideally such display screens should allow a precise measurement of the pixel pitch. Such display screens may have the convenience of being readily available in the vicinity of a typical DIC measuring environment.

It is envisaged that embodiments of the invention will be used in validating a computer model (e.g. a numerical model) of a structure. Such use may be in the context of a method which comprises using a DIC system to take a first image of a speckle pattern applied to a structure constructed according to the computer model, applying a load to the structure, using the DIC system to take a second image of the speckle pattern, then calculating the strain field. The method may include comparing the strain field resulting from the measurements made with the DIC system with a corresponding strain field as predicted with a computer model. It may then be assessed whether the computer model is sufficiently accurate in its predictions in order for it to be validated. The DIC system may be one which is, either before or after, and preferably soon before or soon after, validated by means of a method according to any aspect of the present invention or embodiments thereof as claimed or described herein. In order to be able to use a DIC system as a validated and traceable technique, it is important and beneficial to establish the uncertainty of the DIC measurement system, preferably at about the same time as the tests that are performed by the DIC measurement system. It is preferred therefore that the validation of the DIC system is performed immediately before (or optionally immediately after) using the DIC system to measure the deformation of the structure under loading. It is also beneficial for the real test to use the same sort of setup conditions as that used when the DIC system itself is validated. There may therefore be benefit in using the same sort of pattern when validating the DIC system as is applied to the structure when using the DIC system to validate the computer model of the structure. For example, the size of speckles may be similar. The average density and spacing of speckles may be similar. The display screen may be used to display speckle patterns over a similar area to that of the speckle pattern applied to the structure. It is preferable for the images used when validating the DIC system to be representative of the speckle pattern used on the structure. The type and characteristics (e.g. pitch, resolution, and grey level) of a speckle pattern (as used on the structure) will typically be chosen having regard to the size of the area of interest and the camera's resolution. It may be that the display screen is placed on the structure, or in the equivalent volume occupied by the structure, when validating the DIC system. This may work well in the case where the display screen is formed from flexible material, and is able to conform to the shape of structural component. The method may include taking a photo of the component, to which the speckle pattern has been applied, and using that image, or a part thereof, when validating the DIC

Embodiments are envisaged concerning a method of designing an engineering structure, for example an aircraft structure, utilising a DIC system which is validated by means of a method according to any aspect of the present invention or embodiments thereof as claimed or described herein. Such a method may include steps of creating a computer model of the aircraft structure, and making predictions, with the use of the computer model, concerning the behaviour of the aircraft structure as between first and second loading conditions. A physical model of the aircraft structure may be made to which a random speckle pattern is applied. The DIC system is then used to take a first set of measurements of the random speckle pattern, under a first load condition, which may for example be a condition in which no load is applied. A second load condition, being different from the first load condition, is applied (before or after the first load condition) and a second set of measurements are taken with the DIC system. The DIC system may then ascertain the observed behaviour of the physical model of the aircraft structure (for example by calculating strain field data). There may then be a step of validating the computer model by means of a comparison between the predicted behaviour (for example the predicted strain field data) and the observed behaviour. The step of validating the DIC system may be performed before or after the DIC system is used to take measurements of the random speckle pattern of the physical model of the aircraft structure under a given load condition.

Any known deformation fields can be generated and used to produce a displacement on the structure. For example torsional loads, bending loads and/or multi-axial strain loads may be applied. The structure so designed (and the model thereof having been validated) may then be manufactured. An aircraft component may include such a structure. The aircraft component may form part of an aircraft. There may be application in other fields of engineering or science, and the present invention may have application in relation to other fields of aerospace and defence, the automobile industry, marine engineering, the nuclear industry, the construction industry, civil engineering or other similar fields of application, particularly those that are regulated industries.

The validated DIC system may also be used in a method of certifying a structure, for example an aircraft structure. Such certification will typically include the DIC system measuring the deformation exhibited by a structure under load. Various loads, in accordance with one or more loading profiles, may be applied and the resulting strain fields ascertained. The strain fields ascertained will need to comply with criteria, for example set by or agreed by a certification body, concerning the expected behaviour (which may be referred to as "certification behaviour criteria"). Measurements of the observed behaviour, of the structure under load, are taken by the DIC system (which is or will subsequently be validated in a traceable manner). Strain fields may then be calculated from the deformations measured with the DIC system. A comparison may then be made to test whether the observed behaviour (e.g. resultant strain field calculated) complies with the certification behaviour criteria (e.g. matches an expected strain field to within a given margin). The structure so certified may then be integrated, for example, in an aircraft component, and/or aircraft.

A portable computer including a display screen may be provided to perform at least some of the steps of the methods described herein, for example the steps of displaying images. A computer system including a display screen and being connected to, or forming part of, a digital image correlation system may be provided to perform the methods described herein. The computer system may be one computer, or a plurality of separate computers. Such a portable computer, and such a computer system, may each be programmed with one or more appropriate computer program products. Each such computer program product may thus be configured so that when executed on a computer, the computer performs the function as described or claimed herein.

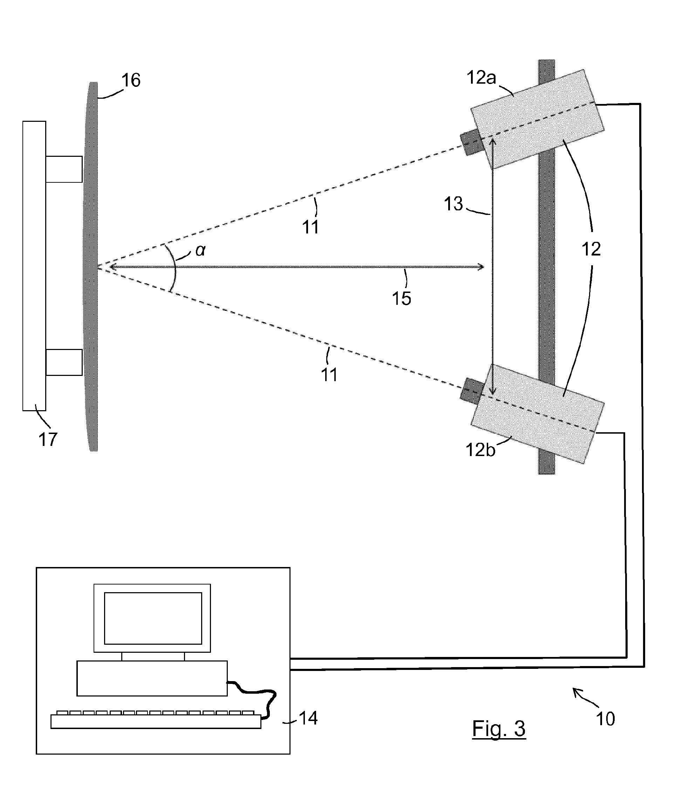

There now follows a description of some specific embodiments, some of which being illustrated by the accompanying drawings. Figure 3 shows a digital image correlation (DIC) system 10 being validated according to a first embodiment. The DIC system comprises a pair of digital cameras 12a, 12b, which in this embodiment are Allied Vision Technologies Dolphin F201-B 2 megapixel resolution cameras with 12 mm focal length lenses at an f/11 aperture. The angle, *α*, between the axes 11 of the cameras is 30 degrees and the lenses of the cameras are separated by a distance 13 of 205mm. The DIC system also comprises a computer 14 that controls the operation of the DIC system 10. The calibration of the setup (a system calibration) is conducted by the computer 14 with the use of a calibration board in a manner that is conventional in the art and therefore not described in further detail here. The calibration builds a model of the physical set-up of the DIC system 10 in the software of the computer 14 accounting for intrinsic characteristics (such as lens distortion, focal length, and sensor alignment etc. of the cameras 12) and extrinsic characteristics (such as the distance 13 and angles *α*, between the cameras). Once the DIC system 10 has been so calibrated, DIC system 10 may then be used to measure strain fields on a specimen, to which a random speckle pattern has been applied, by means of capturing images with the stereo camera pair 12 and post-processing such images with the computer 14.

The present embodiment relates to a method of validating the (previously calibrated) DIC system 10 in a manner that is traceable to a nationally/internationally recognised measurement standard, such as the length standard. (Traceability to international standards via length has been selected as the preferred primary route for both strain and displacement values.) For this purpose a commercially available, high-quality flat computer tablet 16 (in this case an "Apple iPad Air"™) is provided. The tablet computer 16 is mounted on a fixed structure 17 so as to securely fix the tablet in position relative to the cameras 12. The set-up is thus relatively portable. The tablet may for example be mounted at different locations within the field of view of the cameras to validate the DIC system across an area of measurement that is larger than the area of the tablet's display screen.

The stand-off distance 15 between the plane of the screen 16 and the camera lenses is 410mm, the axes of the cameras coinciding (or being closest) at a location at or near the plane of the screen 16. The screen 16 is oriented such that the angle between the axis 11 of each camera 12 and the normal axis of the plane of the screen is about 15 degrees. An artificially generated image of a known random speckle pattern is displayed on the screen 16, and then successive images (at least two) are displayed representing a known deformation/displacement field. The images are thus presented consecutively, in a slideshow format, without interference from the user. The time interval between the display of successive images is about 3 seconds. The items of equipment forming the DIC system 10 remain stationary relative to each other during use. The details of the successive images displayed by the tablet 16 are stored on the computer 14 which controls the cameras and performs the post-processing of the data captured. The imposed deformations, as simulated by the successive images displayed, are thus precisely known, as will now be explained in further detail below.

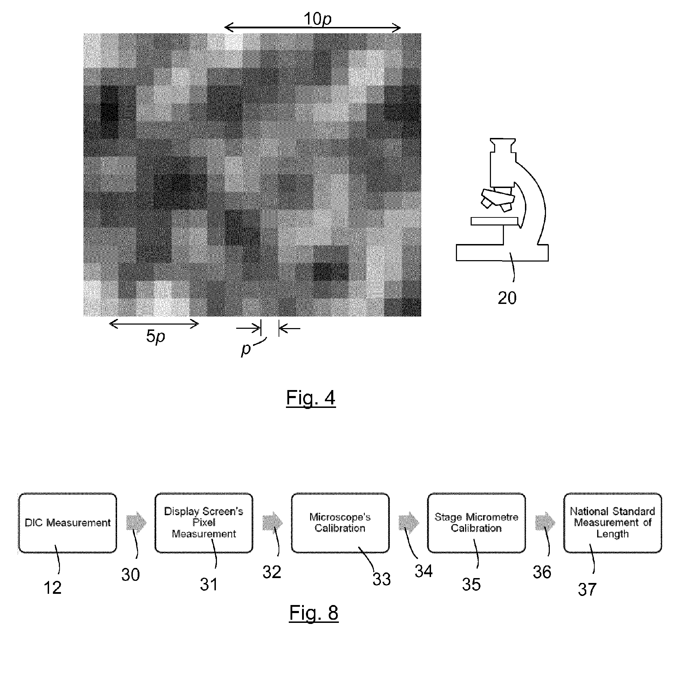

A block of pixels from a random speckle pattern as displayed on the screen 16 is shown in Figure 4. To generate a known deformation/displacement field the resolution of the screen 16 and the exact pixel pitch, *p*, must be known. This is achieved by measuring the pitch of a single pixel, or a distance representing multiple pixel pitches (e.g. 5*p* or 10*p* as shown in Figure 4), with a calibrated microscope 20, which is shown schematically in Figure 4. In order to achieve traceability, the microscope 20 is calibrated to a national (UK) standard measurement of length, as will be described in further detail below.

With precise knowledge of the imposed deformations, the accuracy of the measurements of the deformations made by the DIC measurement system may be tested for that particular setup, resulting in a measure of the uncertainty of the DIC measurements. Each image is captured by the DIC system and then post-processed by the computer 14. Such data may include an indication of the uncertainty in the measurements of the DIC system (of the type typically outputted conventionally - such as the sigma values mentioned below). Post-processing of the data can also result in a pixel by pixel comparison of observed versus expected image displacements/transformations. The data then outputted may then effectively be in the form of the accuracy of the DIC measurement system (as explained in further detail below).

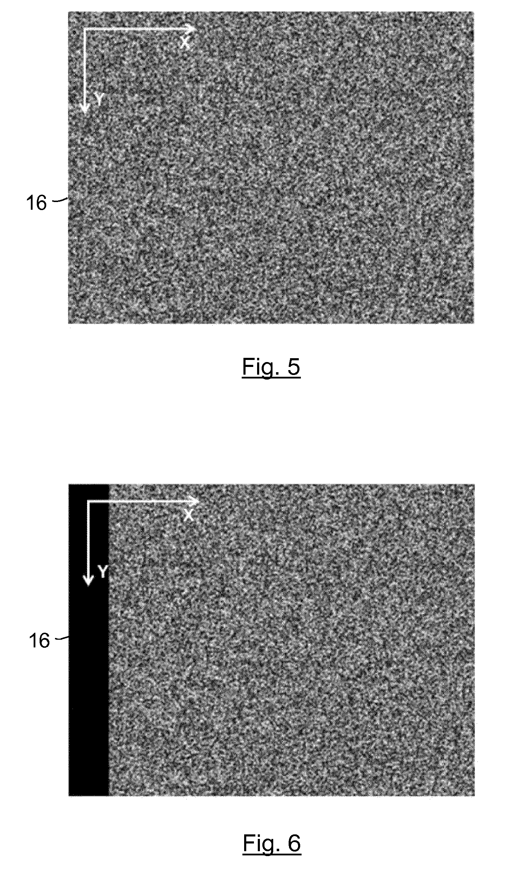

By way of further explanation, Figure 5 shows a speckle pattern displayed on the screen 16 as a first image and Figure 6 shows a second image being displayed on the screen 16, which is a horizontal shift of the speckle pattern to the right (x-direction) by 200 pixels. The images are grayscale images whereby each pixel can be one of 16 possible colours (consisting of white and black and 14 shades of grey therebetween), although it will be appreciated that the iPad has the ability to display a greater number of colours / shades of grey if so desired. The display screen in this case, has a 2048 x 1536 pixel resolution with a pixel density of about 264 ppi (pixels per inch). It will of course be appreciated that a single 'pixel' on a standard display screen will typically comprise at least one red component, at least one green component, and at least one blue component.

Various successive shifts of the image may be performed, in the x-direction, the y-direction, or in both x- and y- directions. In some cases it may be desirable to make measurements of shifts of 0-20 pixels in steps of 1 pixel ("Case 1"). In other cases it may be desirable to make measurements of shifts of 0-100 pixels in steps of 5 pixels at a time ("Case 5"). There may be cases where it is desirable to make measurements of shifts of 0-200 pixels in steps of 10 pixels ("Case 10"). If the pitch between pixels is of the order of 100µm, a shift of 200 pixels would represent a deformation of 20mm. Displacements of approximately 2 mm represent the sort of deformations that are typically seen in small coupon tests performed using a standard test machine in a laboratory setting. Displacements of more than 10 mm are more typical of the displacements seen in larger structural tests, such as a full scale mechanical test. Displacements of the order of 20mm may be observed when performing dynamic tests of structures. Whichever Case is applied, it will be seen that 20 steps are taken, each of an integer number of pixels. In the present embodiment, each image displayed is captured three times. The image shifting process is also repeated, from beginning to end, three times.

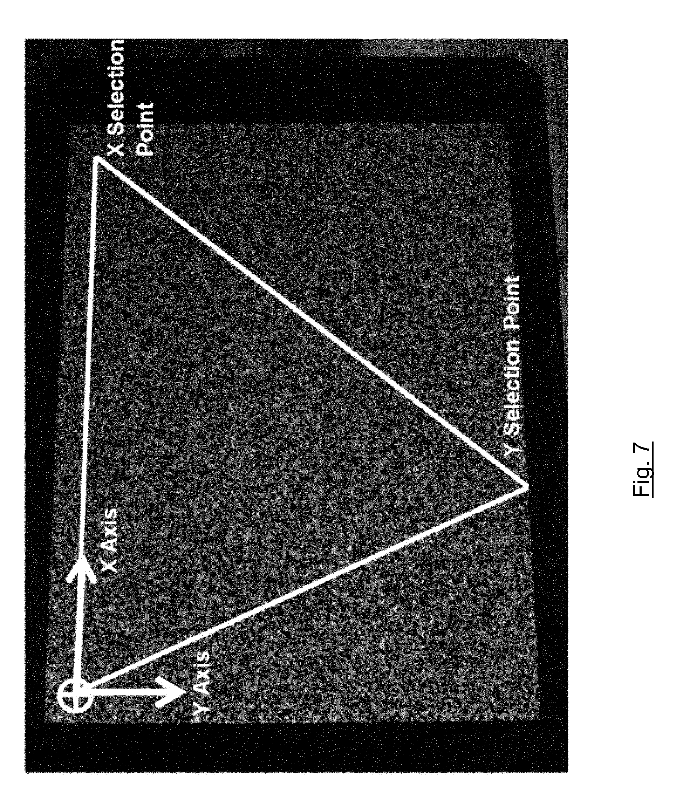

The captured images are post-processed using an area of interest and a coordinate system. As shown in Figure 7, the coordinate system is set using a three point selection technique, namely an origin, an "X Selection Point" that determines the x-axis, and a "Y Selection Point" that, with the other two points, defines the x-y plane and therefore the Y-axis and Z-axis (not shown in Figure 7). The subset size, which determines the size of the data point which is tracked across the captured images, is set at 25x25 pixels so as to be sufficiently large to contain a distinct speckle pattern whilst still computing results in a reasonable time: on average 1.3 seconds per image. Equally, the step size, which determines how many data points are tracked, is (for the present embodiment) set at five pixels as a compromise between providing an acceptable amount of data points and calculation time, yielding approximately 55,000 data points on each image. In addition, a seed point is added in the analysis area, at approximately the same point on the speckle for each analysis, in order to ensure the correlation runs smoothly with the larger pixel shifts. Although not required for successful correlation, the seed point is also added to when making smaller shifts for the sake of consistency. The resulting DIC data, once processed, is in the form of a discrete matrix of data that represents each 25x25 pixel subset area at a step of five pixels. For further statistical analysis, the displacement measurements are extracted from this matrix every 10 data points giving over 4250 measurements for each pixel shift taken from across the analysis area on the display screen, across the three images captured of each shift and across the three repeated tests for the given Case. These subsets have shown, in experiments, a normal distribution of displacement point data results, with a typical standard deviation of 0.28 µm. A single value for the measured displacement for each X and Y shift is then calculated by the computer by means of averaging the measurements from across all the extracted data points from all analyses. This single displacement measurement is converted from millimetres to pixels by dividing by the measured pixel pitch in X and Y directions (96.15 µm and 96.04 µm, respectively, in this embodiment). A standard deviation of the single displacement measurement so ascertained may also be calculated from the data acquired.

It will be appreciated that the DIC system itself produces an uncertainty in its measurements, which may be outputted in the form of an array of sigma values, each sigma value being a measure of the inherent uncertainty in the position of the pixel as measured by the DIC system. Such sigma values are typically less than 0.01 pixels. This measure, of the inherent uncertainty of the measurements made by the DIC system, are also accounted for when validating the DIC system.

A single error value, in pixels, is calculated by the computer for each shift, essentially by subtracting the single DIC measurement value from the imposed, true value, of the shift of the image. Additionally, a normalised form of this error value is calculated by dividing the error value (in pixels) by the corresponding imposed shift (in pixels).

The error of the measurement in pixels is calculated at each imposed pixel shift value, as the difference between the true value (the imposed integer value) and the measured value of the pixel shift, determined from the extracted DIC data supplied by post-processing analysis. Normalised errors, calculated by dividing the measurement error value by its corresponding imposed shift value, are also calculated in respect of the pixel shifts in both X and Y directions. A typical normalised error range might be of the order of -0.005 to +0.005 pixels, equating to a maximum error range of ± 0.5µm, for all 0-200 pixel shifts in X and Y directions. The error range may be quoted together with a standard deviation, or confidence metric, to provide an indication of the variation in the data that results in the error range so calculated.

The above method thus provides a means of calculating an error value, with a standard deviation, representing the accuracy of the DIC measurement system by means of measuring the deviations between a known imposed deformation displayed on the screen and the deformation as measured by the DIC system. This then provides a means for validating a calibrated DIC measurement system by providing a quantitative indication of the uncertainty of the measurements performed by that particular DIC setup. As mentioned above, the validation technique is also traceable, thus enabling the validated DIC system to be used as a traceable measurement technique. This is achieved through the precise measurement of the screen's pixel pitch using a calibrated device, creating a traceable measurement chain back to the length standard.

The traceability chain used in this embodiment is shown in Figure 8. Thus, the uncertainty of the measurements made with the DIC measurement system 12 is ascertained (link 30), and therefore the measurements validated, with reference to a known pixel pitch measurement 31. A "ZEISS Axioskop 2 MAT" microscope 20 with a 20x objective lens is used to measure (link 32) the pixel pitch (in both X and Y directions). The microscope 20 is, in turn, itself calibrated (illustrated by calibration 33 in Fig. 8) for measurement in ZEISS' "AxioVision Rel 4.8" software with reference (link 34) to a 100x0.1=10mm Pyser-SGI Ltd. PS1R stage micrometre graticule 35. The stage micrometre is itself calibrated (link 36), with direct reference to the national length standard 37, completed in accordance to UKAS requirements. This is achieved by performing three repeated measurements using a laser interferometer of each 1 mm graduation on the scale of the graticule from 1 mm to 10 mm. A single value for combined standard uncertainty is calculated using the root sum square of the standard deviations of each set of repeated measurements. Thermal expansion effects may need to be accounted for, if there are variations in temperature as between the validation steps and the measurements made along the traceability chain, but in the present embodiment were judged to be sufficiently low as to be negligible.

The validation method described above in relation to Figures 3 to 8 provides validation of full-field, stereo DIC measurement systems in an industrial environment in a way which is traceable to the length standard, in a simple and elegant manner.

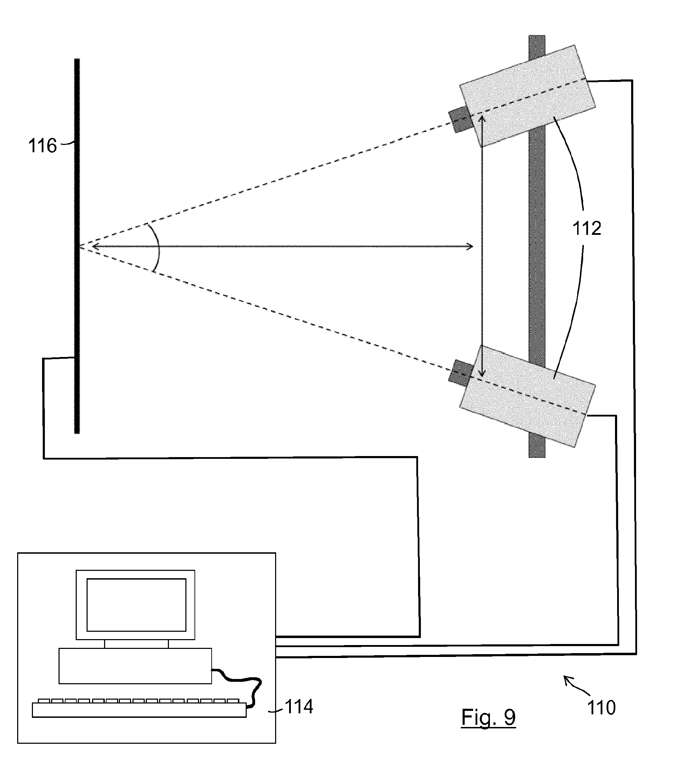

Figure 9 shows a DIC measurement system 110 according to a second embodiment, which is similar in set-up to the first embodiment. The second embodiment differs from the first embodiment principally in that a high-definition computer monitor is utilised as the display screen. The display screen 116 used is an AG Neovo RX-W32 LCD television screen having a resolution of 1920x1080 pixels. The television screen's pixel pitch is of the order of 360µm.

The display screen 116 is connected to the computer 114. The same computer 114 can thus be used to control both the DIC system 110 and the display screen 116.

A third embodiment, not separately illustrated, uses an e-ink monochrome display screen. This embodiment is similar to the second, in that the display screen is separate from the computer that controls the camera pair.

A fourth embodiment, not separately illustrated, uses a flexible display screen based on OLED (Organic Light Emitting Diodes) technology. This embodiment is similar to the second, in that the display screen is separate from the computer that controls the camera pair. The flexible screen is non-planar in use, and thus relies on the DIC measurement systems ability to locate a point in 3-D space by means of the use of only two cameras. It will be appreciated that the x- and y- axes of the coordinate system defined in space will not, in this embodiment, be parallel to either the rows or the columns of pixels of the non-planar display screen. The flexible display has the advantage however of being able to conform to a shape that is similar to the structure, or a part thereof, to be measured by the DIC system. In use, the flexible display is temporarily fixed, with suction cups, to the outer surface of the structure that will be measured with the DIC system.

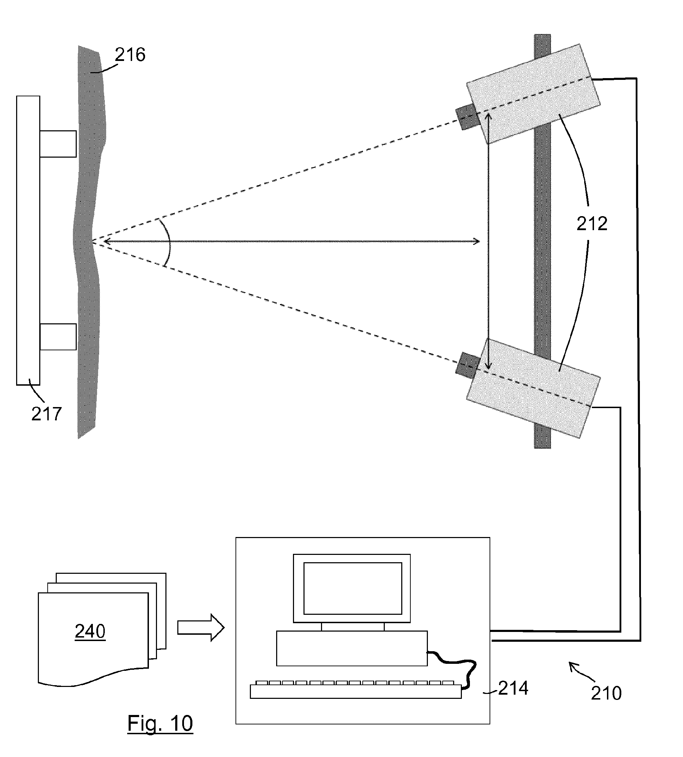

With reference to Figure 10, a fifth embodiment relates to the use of a calibrated and validated DIC system 210 being used to validate a computational model 240 of a structure, by means of loading a physical structure 216 ("test specimen") made to the model. A random speckle pattern is applied to the structure 216. The physical structure 216 is mounted on a mounting system 217 and loading conditions are applied. The resulting deformations are viewed with the cameras 212 and the strain field calculated by computer 214. The strain field so calculated from the measurements made with the DIC system are compared with the strain field predicted by the computational model and if the two match (within predefined tolerances) the computational model is validated. The validation of the DIC system used in the method of the fifth embodiment is carried out immediately beforehand with the display being placed on (or directly adjacent to) the test specimen, or at least in the same environment as the test specimen will be tested. It is ensured that the positioning of the display is such that the during validation test, the display remains completely stationary. The images used in the validation process are representative of the speckle pattern used on the test specimen and the pattern is optimised with regards to the size of the area of interest and the cameras' resolution. The validation conditions closely represent the real test setup conditions.

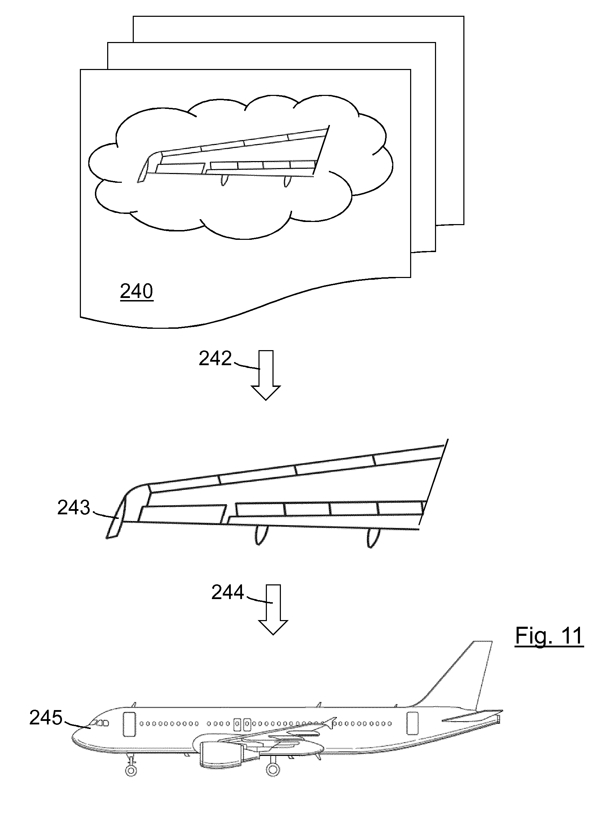

With reference to Figure 11, the validated computer model 240 of the component (in this case a part of an aircraft wing), can then be manufactured (step 242), incorporated into an aircraft structure, such as a wing section 243, and then assembled (step 244) with other components to form an aircraft 245.

Whilst the present invention has been described and illustrated with reference to particular embodiments, it will be appreciated by those of ordinary skill in the art that the invention lends itself to many different variations not specifically illustrated herein. By way of example only, certain possible variations will now be described.

The calibration / validation method can utilise display screens of different sizes and scales, for example to cater for different types and scales of test setups. Images representing various different types and degrees of deformation from those described above may be displayed in alternative embodiments. High resolution screens with a higher pixel density than described above could be custom-made to improve and extend the applicability of the above embodiments. Instead of imposing a simple linear shift in one direction of an integer number of pixels, the imposed transformation.

Other microscope, or indeed other measure devices, could be used to measure the pixel pitch. For example a portable, Peak Direct/Depth Measuring Wide Stand Microscope with a 60x magnification could be used.

Other types of geometric transformations may be imposed and then measured in the calibration / validation methods disclosed. For example the image may be simply rotated, with a one-to-one mapping for each display pixel representing the image before and after the rotation, by 90 degrees.

Tests could be performed in a temperature controlled environment, for example at 21 °C, for increased accuracy and improved traceability.

Synthetic speckle images could be created and customized for the specific display screen to be used and in view of the imposed deformation/measurement to be simulated. Such synthetic speckle images may be designed to have low noise level and beneficial DIC parameters, such as a suitable subset size. A speckle size of approximately 4-5 pixels per 'speckle' could be beneficial in certain embodiments for example. Synthetic speckle images may be optimised for a particular purpose, by means of using multiple different synthetic speckle images in a sequence of validation tests for a particular set-up of a DIC system, and then selecting the best performing speckle image for the subsequent measurements to be made with the DIC system.

The display screen need not necessarily be rigidly supported in its location during performance of the validation method. For example, a tablet-based display screen could be maintained in position simply by resting it on top of a stationary support surface.

Where in the foregoing description, integers or elements are mentioned which have known, obvious or foreseeable equivalents, then such equivalents are herein incorporated as if individually set forth. Reference should be made to the claims for determining the true scope of the present invention, which should be construed so as to encompass any such equivalents. It will also be appreciated by the reader that integers or features of the invention that are described as preferable, advantageous, convenient or the like are optional and do not limit the scope of the independent claims. Moreover, it is to be understood that such optional integers or features, whilst of possible benefit in some embodiments of the invention, may not be desirable, and may therefore be absent, in other embodiments.

## Claims

1. A method of validating a digital image correlation system, wherein the method comprises the following steps:
a) displaying a random speckle pattern, as a first image, on a display screen having a stack of a plurality of lines of pixels, adjacent pixels in each line being separated by a known pitch, the pitch having been measured against a standard,
b) using the digital image correlation system that requires validation to take a first set of measurements of the random speckle pattern,
c) displaying a second image, in which the random speckle pattern of the first image has undergone an imposed geometric transformation, such that one or more blocks of the first image are mapped onto one or more blocks of the second image in a one-to-one mapping, each block being represented on screen as an integer number of pixels,
d) ascertaining a measured geometric transformation including taking a second set of measurements with the digital image correlation of the random speckle pattern, and
e) comparing the imposed geometric transformation and the measured geometric transformation.

2. A method according to claim 1, wherein the imposed geometric transformation is such that the one or more blocks of the first image, and the one or more blocks of the second image, are each represented on screen as a single pixel, whereby the geometric transformation is such that individual blocks of the first image shift an integer number of pixels to form the individual blocks of the second image.

3. A method according to claim 1 or claim 2, wherein the imposed geometric transformation is such the whole of the random speckle pattern is shifted, in the direction along the length of each line, on the display screen by an integer number of pixels.

4. A method according to any preceding claim, wherein the random speckle pattern consists of pixels each having a colour that is equal to one of a set of colours, the set comprising more than three colours.

5. A method according to any preceding claim, wherein the display screen is non-planar and/or is formed from flexible material that is able to conform to different shapes.

6. A method according to any preceding claim, wherein the method includes a step, which is conducted before step e), of calibrating the digital image correlation system, and which optionally includes displaying a calibration pattern on the same display screen as is used to display the random speckle pattern in step a).

7. A method of calibrating a digital image correlation system, wherein the method comprises the following steps:
a) displaying a known pattern on a display screen having a stack of a plurality of lines of pixels, the centres of adjacent pixels in each line being separated by a known pitch, and the distance from the centreline of one line of pixels to the centreline of an adjacent line of pixels being a known separation distance, the pitch and the separation distance each having been measured against a standard,
b) using the digital image correlation system that requires calibration to take a set of measurements of the known pattern,
c) repeating steps a) and b) above a plurality of times, and
d) calculating calibration parameters for the digital image correlation system from the results of step c).

8. A digital image correlation system as validated by a method according to any of claims 1 to 6 or as calibrated by a method according to claim 6 or 7.

9. A method of validating a computer model of a structure, wherein the method comprises the following steps:
i. performing the method of any of claims 1 to 6 so as to provide a validated digital image correlation system,
ii. immediately before or after step i), using the digital image correlation system to take a first image of a speckle pattern applied to a structure made according to the computer model, the speckle pattern applied to the structure optionally being the same sort of pattern as used in step i) to validate the digital image correlation system,
iii. applying a load to the structure,
iv. using the digital image correlation system to take a second image of the speckle pattern,
v. using the digital image correlation system to calculate the strain field, and
vi. comparing the strain field resulting from the measurements made with the validated digital image correlation system with a corresponding strain field as predicted with the computer model.

10. A method of designing an aircraft structure, comprising the steps of
a) creating a computer model of the aircraft structure,
b) making predictions, with the use of the computer model, concerning the behaviour of the aircraft structure as between first and second loading conditions,
c) making a physical model of the aircraft structure,
d) applying a random speckle pattern on at least a part of the physical model of the aircraft structure,
e) using a digital image correlation system to take a first set of measurements of the random speckle pattern, under a first load condition,
f) applying to the physical model of the aircraft structure a second load condition, being different from the first load condition,
g) taking a second set of measurements with the digital image correlation system of the random speckle pattern, under the second load condition,
h) ascertaining the observed behaviour of the physical model of the aircraft structure with the digital image correlation system,
i) validating the computer model by means of a comparison between the predicted behaviour and the observed behaviour, and
j) validating the digital image correlation system by means of performing the method of any of claims 1 to 6.

11. A method of certifying an aircraft structure, comprising the steps of
a) providing a loading profile to be applied to an aircraft structure,
b) providing certification behaviour criteria with which the aircraft structure must comply when loaded by the loading profile,
c) applying the loading profile to the aircraft structure on which there is provided a random speckle pattern,
d) using a digital image correlation system to take measurements both before the loading profile is applied and during when the loading profile is applied,
e) ascertaining the observed behaviour of the aircraft structure with the digital image correlation system of claim 8, and
f) ascertaining whether the observed behaviour complies with the certification behaviour criteria.

12. An aircraft component including an aircraft structure made from a computer model of the aircraft structure, which has been validated by the method according to claim 10 and/or which has been certified by the method of claim 11.

13. A portable computer with a display screen, wherein the portable computer is programmed with a computer program product configured to cause, when the computer program is executed, the portable computer to perform steps a) and c) of claim 1.

14. A computer system including a display screen and being connected to form part of a digital image correlation system, wherein the computer system is programmed with one or more computer program products configured to cause, when the computer program is executed, the computer system to perform the steps of the method of any of claims 1 to 7.

15. A computer program product as defined in claim 13 or claim 14.
